(19) Europäisches Patentamt / European Patent Office / Office européen des brevets

(11) **EP 3 479 012 B1**

(12) **FASCICULE DE BREVET EUROPEEN**

(45) Date de publication et mention
de la délivrance du brevet:
**03.03.2021 Bulletin 2021/09**

(21) Numéro de dépôt: **17734696.2**

(22) Date de dépôt: **26.06.2017**

(51) Int Cl.:
*F21S 41/00* (2018.01)    *C09K 11/02* (2006.01)
*C09K 11/08* (2006.01)    *F21K 2/00* (2006.01)
*H01L 33/52* (2010.01)    *H01L 27/15* (2006.01)
*B82Y 20/00* (2011.01)

(86) Numéro de dépôt international:
**PCT/EP2017/065659**

(87) Numéro de publication internationale:
**WO 2018/001938 (04.01.2018 Gazette 2018/01)**

(54) **DISPOSITIF D'ÉCLAIRAGE ET/OU DE SIGNALISATION AMÉLIORÉ, NOTAMMENT POUR VÉHICULE AUTOMOBILE**

VERBESSERTE SIGNALISIERUNGS- UND/ODER BELEUCHTUNGSVORRICHTUNG, INSBESONDERE FÜR EIN KRAFTFAHRZEUG

AN IMPROVED SIGNALLING AND/OR LIGHTING DEVICE, IN PARTICULAR FOR A MOTOR VEHICLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.06.2016 FR 1656264**

(43) Date de publication de la demande:
**08.05.2019 Bulletin 2019/19**

(73) Titulaire: **Valeo Vision**
**93012 Bobigny Cedex (FR)**

(72) Inventeur: **ALBOU, Pierre**
**93012 Bobigny Cedex (FR)**

(74) Mandataire: **Valeo Visibility**
**IP Department**
**34, rue Saint André**
**93012 Bobigny (FR)**

(56) Documents cités:
**EP-A1- 2 386 793        WO-A1-2017/025440**
**US-A1- 2012 132 888     US-A1- 2014 175 978**
**US-A1- 2015 207 038     US-A1- 2016 172 339**

## Description

Le domaine de l'invention se rapporte aux dispositifs d'éclairage et/ou de signalisation, notamment pour véhicule automobile.

Les dispositifs d'éclairage et/ou de signalisation comprennent généralement un module d'émission lumineuse adapté pour générer de la lumière.

Parmi les modules de ce type, on connaît des modules dont le cœur d'émission comprend une source d'émission lumineuse reposant sur l'emploi de diodes électroluminescentes classiques.

Ce cœur d'émission peut être associé à une couche de conversion au voisinage des diodes et configurée pour convertir au moins une partie de la lumière émise par les diodes en une lumière convertie. La lumière convertie aboutit à la fourniture par le dispositif d'une lumière résultante de couleur choisie, éventuellement par combinaison avec la lumière émise par les diodes qui n'est pas absorbée par la couche de conversion.

Le document US2015/207038 décrit une source de lumière comprenant une pluralité de bâtonnets électroluminescents, un revêtement comprenant une couche de remplissage et une unité de conversion de longueur d'onde comprenant des phosphores. L'unité de conversion est située au-dessus du revêtement comme un élément à part.

Le document US2012/132888 décrit une source de lumière comprenant une pluralité de bâtonnets électroluminescents, un matériau d'enrobage et des éléments de conversion.

L'une des difficultés afférentes à ce type de configuration est l'obtention d'une couche de conversion ayant de bonnes propriétés, et se traduisant notamment par l'obtention d'une couleur fournie par le module présentant une faible variabilité en fonction de la direction d'observation.

Aussi, l'invention vise à améliorer la situation.

A cet effet, l'invention concerne une source d'émission lumineuse, notamment pour véhicule automobile, la source d'émission lumineuse comprenant :

- une pluralité de bâtonnets électroluminescents de dimensions submillimétriques configurés pour émettre de la lumière, et
- un revêtement adapté pour encapsuler les bâtonnets électroluminescents et pour convertir au moins une partie de la lumière émise par les bâtonnets en une lumière convertie, le revêtement comprenant :

  ◦ un matériau d'enrobage dans laquelle au moins une partie des bâtonnets électroluminescents est enrobée, et
  ◦ un matériau de conversion adapté pour générer ladite lumière convertie à partir de la lumière émise par les bâtonnets électroluminescents, le matériau de conversion comprenant une pluralité de grains luminophores, les grains luminophores se situant dans une zone du revêtement s'étendant au-delà d'extrémités libres des bâtonnets électroluminescents, les grains luminophores présentant des dimensions configurées pour prévenir la présence desdits grains luminophores entre des espaces délimités latéralement entre les bâtonnets électroluminescents, les grains présentant un diamètre minimal supérieur à la plus grande des distances d'un ensemble de distances définies entre deux bâtonnets voisins dans une zone d'émission.

Selon un aspect de l'invention, les bâtonnets électroluminescents sont noyés dans le matériau d'enrobage.

Selon un aspect de l'invention, au moins une partie des grains luminophores est accumulée au sein d'une épaisseur du revêtement qui surplombe l'extrémité libre des bâtonnets électroluminescents.

Selon un aspect de l'invention, ladite épaisseur est au contact de l'extrémité libre des bâtonnets électroluminescents.

Selon un aspect de l'invention, ladite zone du revêtement présente une épaisseur comprise entre 10 et 100 micromètres.

Selon un aspect de l'invention, pour au moins une partie des bâtonnets électroluminescents, des bâtonnets électroluminescents voisins définissent entre eux latéralement des espaces, les grains présentant un diamètre minimal supérieur à la plus grande des distances d'un ensemble de distances entre deux bâtonnets électroluminescents définissant conjointement un desdits espaces.

Selon un aspect de l'invention, le matériau de revêtement comprend un polymère thermoplastique ou thermodurcissable.

Selon un aspect de l'invention, ledit matériau comprend un polysiloxane.

Selon un aspect de l'invention, les grains luminophores comprennent au moins un composé luminophore pris seul ou en combinaison parmi : $Y_3Al_5O_{12}:Ce^{3+}$ (YAG), $(Sr,Ba)_2SiO_4:Eu^{2+}$, $Ca_x(Si,Al)_{12}(O,N)_{16}:EU^{2+}$, $CaAlSiN_3:Eu^{2+}$, $Ca_2Si_5N_8:Eu^{2+}$, $La_2O_2S:Eu^{3+}$, $(Sr, Ca, Ba, Mg)_{10}(PO_4)_6Cl_2:Eu^{2+}$, $BaMgAl_{10}O_{17}:Eu^{2+}$, $(Si, Al)_6(O, N):Eu^{2+}$, $BaMgAl_{10}O_{17}:Eu^{2+}Mn^{2+}$, $SrS:Eu^{2+}$, $Sr_2Si_5N_8:Eu^{2+}$, $SrGa_2S_4:Eu^{2+}$, $(Y,Gd)_3(Al, Ga)_5O_{12}:Ce^{3+}$ / $(Ba,Sr,Ca)Si_2O_4:Eu^{2+}$.

Selon un aspect de l'invention, le module d'émission lumineuse comprend une source d'émission lumineuse selon l'une quelconque des revendications précédentes.

Selon un aspect de l'invention, le module d'émission lumineuse comprend en outre un substrat à partir duquel les bâtonnets électroluminescents s'étendent.

Selon un aspect de l'invention, le module d'émission lumineuse comprend en outre un module de contrôle adapté pour commander l'alimentation en énergie électrique des bâtonnets électroluminescents.

Selon un aspect de l'invention, le module d'émission lumineuse comprend en outre une optique de mise agencée pour recevoir la lumière émise par le module d'émission lumineuse pour former un faisceau lumineux.

L'invention concerne en outre un dispositif d'émission lumineuse, notamment pour véhicule automobile, comprenant un module d'émission lumineuse tel que défini ci-dessus.

Selon un aspect de l'invention, le dispositif d'émission lumineuse comprend en outre un élément optique de mise en forme adapté pour recevoir la lumière par le module d'émission lumineuse pour former un faisceau de sortie du dispositif d'émission lumineuse.

Selon un aspect de l'invention, le dispositif d'émission lumineuse étant configuré pour mettre en œuvre une fonction photométrique, notamment réglementaire.

L'invention concerne en outre un procédé de fabrication d'une source d'émission lumineuse selon l'une quelconque des revendications précédentes, le procédé comprenant :

- une étape d'obtention des bâtonnets électroluminescents,
- une étape de formation au cours de laquelle on forme, sur les bâtonnets électroluminescents de la source de lumière, une couche de préparation destinée à former tout ou partie du revêtement adapté pour encapsuler les bâtonnets électroluminescents et pour convertir au moins une partie de la lumière émise par les bâtonnets en une lumière convertie,
- une étape de déformation au cours de laquelle la couche de préparation est déformée de façon à emplir des espaces délimités latéralement entre les bâtonnets, et
- une étape postérieure à l'étape de déformation au cours de laquelle on forme le revêtement à partir d'au moins la couche de préparation.

Selon un aspect de l'invention, le procédé comprend en outre une étape d'introduction préalable ou postérieure à l'étape de formation et/ou à l'étape de déformation et au cours de laquelle on introduit les grains luminophores dans un matériau à partir duquel la couche de préparation est réalisée, dans la couche de préparation ou dans un matériau obtenu à partir de la couche de préparation.

Selon un aspect de l'invention, l'étape d'introduction est préalable à l'étape de formation, les grains luminophores étant introduits dans le matériau à partir duquel la couche de préparation est réalisée.

Selon un aspect de l'invention, l'étape d'introduction est postérieure à l'étape de formation, les grains luminophores étant introduits dans la couche de préparation.

Selon un aspect de l'invention, l'étape d'introduction est postérieure à l'étape de déformation, les grains luminophores étant introduits dans la couche de préparation une fois la couche de préparation déformée.

Selon un aspect de l'invention, le matériau de la couche de préparation comprend un précurseur du matériau d'enrobage, le précurseur étant transformé en le matériau d'enrobage pour former le revêtement à partir de la couche de préparation.

Selon un aspect de l'invention, l'étape d'introduction est postérieure à la transformation du précurseur en le matériau d'enrobage, les grains luminophores étant introduits dans le matériau d'enrobage pour la formation du revêtement.

Selon un aspect de l'invention, la couche de préparation est thermoplastique, et, lors de l'étape de déformation, on chauffe la couche de préparation pour la déformer.

Selon un aspect de l'invention, la couche de préparation est thermodurcissable, et, suite à l'étape de déformation, on chauffe au moins la sous-couche d'encapsulation pour la durcir.

L'invention sera mieux comprise à la lecture de la description détaillée qui va suivre, donnée uniquement à titre d'exemple et faite en référence aux Figures annexées, sur lesquelles :

- La Figure 1 est une illustration d'un dispositif d'émission lumineuse, notamment d'éclairage et/ou signalisation selon l'invention ;
- La Figure 2 est une illustration d'un module d'émission lumineuse selon l'invention ;
- La Figure 3 est un diagramme-bloc illustrant un procédé de fabrication du module d'émission de la Figure 2 ; et
- Les Figures 4 et 5 illustrent des étapes du procédé de la Figure 3.

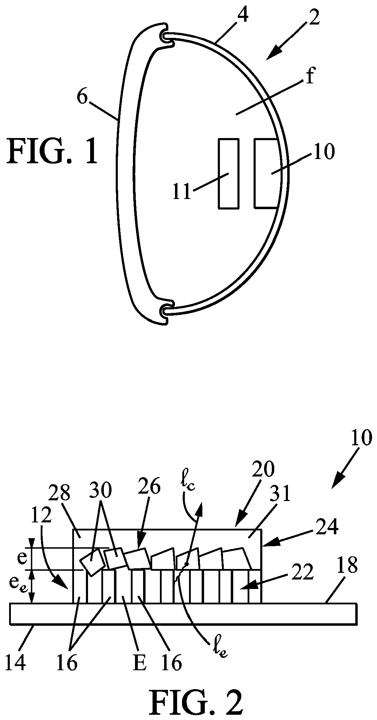

La Figure 1 illustre un dispositif d'émission lumineuse 2 selon l'invention configuré pour émettre de la lumière.

Le dispositif est avantageusement un dispositif destiné à être intégré à un véhicule automobile. Avantageusement, le dispositif d'émission lumineuse 2 est un dispositif d'éclairage et/ou de signalisation de véhicule automobile.

Il est par exemple configuré pour mettre en œuvre une ou plusieurs fonctions photométriques.

Une fonction photométrique est par exemple une fonction d'éclairage et/ou signalisation visible pour un œil humain. On remarque que ces fonctions photométriques peuvent faire l'objet d'une ou plusieurs réglementations établissant des exigences de colorimétrie, d'intensité, de répartition spatiale selon une grille dite photométrique, ou encore de plages de visibilité de la lumière émise.

Le dispositif d'émission lumineuse 2 est par exemple un dispositif d'éclairage et constitue alors un projecteur - ou phare avant - de véhicule. Il est alors configuré pour mettre en œuvre une ou plusieurs fonctions photométriques par exemple choisie(s) parmi une fonction de feux de croisement dite « fonction code » (réglementations 87 et 123 UNECE), une fonction feu de position (réglementation 007 UNECE), une fonction de feux de route dite « fonction route » (réglementation 123 UNECE), une fonction antibrouillard (réglementations 019 et 038 UNECE).

Alternativement, le dispositif est un dispositif de signalisation destiné à être agencé à l'avant ou à l'arrière du véhicule.

Lorsqu'il est destiné à être agencé à l'avant, ces fonctions photométriques incluent une fonction d'indication de changement de direction (réglementation 006 UNECE), une fonction d'éclairage diurne connue sous l'acronyme anglophone DRL (réglementation 087 UNECE), pour « Daytime Running Light », une fonction de signature lumineuse avant.

Lorsqu'il est destiné à être agencé à l'arrière, ces fonctions photométriques incluent une fonction d'indication de recul (réglementation 023 UNECE), une fonction stop (réglementation 007 UNECE), une fonction antibrouillard (réglementations 019 et 038 UNECE), une fonction d'indication de changement de direction (réglementation 006 UNECE), une fonction de signature lumineuse arrière.

Alternativement, le dispositif d'émission lumineuse 2 est prévu pour l'éclairage de l'habitacle d'un véhicule et est alors destiné à émettre de la lumière principalement dans l'habitacle du véhicule.

Dans ce qui suit, le dispositif d'émission lumineuse 2 est décrit de manière non limitative dans une configuration dans laquelle il est destiné à émettre de la lumière à l'extérieur du véhicule.

En référence à la Figure 1, le dispositif d'émission lumineuse 2 comprend un boîtier 4 et une glace de fermeture 6 coopérant l'un avec l'autre pour délimiter intérieurement une cavité 8.

Le dispositif d'émission lumineuse 2 comprend en outre un module d'émission lumineuse 10 selon l'invention, ci-après module 10, agencé en tout ou partie dans la cavité 8. Optionnellement, le dispositif d'émission lumineuse 2 comprend en outre un élément optique de mise en forme 11 agencé pour recevoir une partie de la lumière émise par le module 10 pour former un faisceau de sortie du dispositif d'émission lumineuse 2 (éventuellement conjointement à la glace 6).

Par élément optique de mise en forme, on entend un élément adapté pour dévier au moins un des rayons lumineux émis par le module 10. Ici, cet élément 11 est par exemple configuré pour former un faisceau dirigé vers la glace 6.

Le module 10 est configuré pour émettre de la lumière. Par exemple, dans l'exemple de la Figure 1, il est agencé pour émettre de la lumière en direction de l'élément 11.

En référence à la Figure 2, le module 10 comprend une source de lumière 12 configurée pour émettre de la lumière, et un substrat 14.

La source de lumière 12 forme le cœur d'émission lumineuse du module 10 et du dispositif d'émission lumineuse 2 (éventuellement conjointement à d'autres modules d'émission lumineuse).

Dans le contexte de l'invention, la source de lumière 12 est une source de lumière à semi-conducteur. Autrement dit, elle comprend au moins un élément semi-conducteur adapté pour émettre de la lumière ou un rayonnement électromagnétique. Dans le contexte de l'invention, la source de lumière 12 comprend des unités électroluminescentes 16 de dimensions submillimétriques adaptées pour émettre de la lumière ou un rayonnement électromagnétique. Ces unités correspondent par exemple à des bâtonnets.

Le rayonnement électromagnétique peut appartenir notamment au domaine des rayonnements ultraviolets.

La description qui suit est faite de manière non limitative dans le cadre où les unités sont des bâtonnets.

Le substrat 14 forme un support pour les bâtonnets 16. Le substrat 14 est adapté pour l'alimentation en énergie électrique des bâtonnets 18. A cet effet, il comprend une ou plusieurs pistes métallisées adaptées pour acheminer de l'énergie électrique issue d'une source d'énergie électrique (non représentée) aux bâtonnets 16. Cette ou ces pistes sont avantageusement configurées pour connecter tout ou partie des bâtonnets entre eux de façon à définir un ou plusieurs sous-groupes de bâtonnets 16, et pour autoriser l'alimentation sélective du ou de ces sous-groupes. Le contrôle de l'alimentation des sous-groupes est avantageusement réalisé par l'intermédiaire d'un module de contrôle formant partie du module 10.

Le substrat 14 se présente sous la forme d'une plaque. Par exemple, le substrat est sensiblement plan.

Le substrat est par exemple réalisé à partir de silicium ou de carbure de silicium.

Le substrat comprend une face 18 au contact de laquelle les bâtonnets 16 sont agencés. Les bâtonnets 16 sont par exemple agencés sur une zone centrale de cette face 18, qui présente alors optionnellement des bords ne portant pas de bâtonnet 16.

Optionnellement, le module 10 comprend un dissipateur thermique configuré pour évacuer de la chaleur générée par les bâtonnets électroluminescents. Le dissipateur thermique est par exemple rapporté au substrat au niveau d'une face de celui-ci opposée à la face 18.

Les bâtonnets 16 sont configurés pour émettre de la lumière ou un rayonnement électromagnétique. Par exemple, les bâtonnets 16 sont configurés pour émettre de la lumière de couleur bleue, rouge ou verte ou encore un rayonnement électromagnétique appartenant au domaine des rayonnements ultraviolets.

Les bâtonnets 16 se présentent sous la forme de plots de petites dimensions présentant une ou des faces latérales et une extrémité libre opposée au substrat. Cette extrémité se présente par exemple sous la forme d'une face d'extrémité. Les bâtonnets sont adaptés pour émettre de la lumière ou un rayonnement électromagnétique par leurs faces latérales. Optionnellement, ils émettent aussi de la lumière ou un rayonnement électromagnétique par la face d'extrémité.

Les bâtonnets 16 s'étendent en saillie à partir de la face 18 du substrat 14. Les bâtonnets 16 s'étendent par exemple sensiblement parallèlement les uns aux autres. Par exemple, ils s'étendent perpendiculairement au substrat.

Chaque bâtonnet 16 présente par exemple une forme générale cylindrique s'étendant selon un axe longitudinal. Par exemple, ils présentent une section circulaire ou polygonale. Alternativement, ils présentent une section de forme quelconque.

Les bâtonnets 16 sont de dimensions submillimétriques. En d'autres termes, leurs dimensions sont inférieures à un millimètre. En outre, ils présentent une hauteur supérieure ou égale à un micromètre. Par exemple, cette hauteur est comprise entre 2 et 10 $\mu$m.

Du fait de la présence de ces bâtonnets 16, la source 12 est une source de lumière à semi-conducteurs en trois dimensions, par opposition aux sources de lumière composées d'éléments photoémissifs de type diode électroluminescente, qui forment des sources sensiblement planes se présentent sous la forme d'une couche mince, leur épaisseur étant de l'ordre de quelques nanomètres.

Les bâtonnets 16 sont par exemple réalisés à partir de nitrure de gallium (GaN), d'un alliage de nitrure d'aluminium et de nitrure de gallium (AlGaN), ou à partir d'un alliage d'aluminium, d'indium, de gallium et/ou de phosphore (AlInGaP).

Par exemple, ils sont formés sur le substrat 14 par croissance épitaxiale.

Les bâtonnets 16 comprennent un noyau, par exemple en nitrure de gallium, autour duquel sont disposés des puits quantiques formés par une superposition de couches de matériaux différents, par exemple du nitrure de gallium et du nitrure de gallium-indium. En outre, ils comprennent une coque entourant les puits quantiques, par exemple également réalisées en nitrure de gallium. Cette coque est par exemple revêtue d'une couche d'oxyde conducteur transparent (OCT) qui forme une anode du bâtonnet complémentaire à la cathode formée par le substrat 14.

Les bâtonnets 16 sont agencés sur le substrat 14 de façon à définir au moins une zone d'émission de lumière présentant une densité élevée de bâtonnets. Par exemple, au sein de cette zone, les bâtonnets sont distribués de manière régulière, par exemple selon un agencement sensiblement matriciel organisé selon deux directions. Ces directions sont par exemple orthogonales, les bâtonnets étant agencés en lignes et colonnes. Alternativement, l'agencement des bâtonnets au sein d'une zone d'émission est quelconque.

Les bâtonnets d'une zone d'émission définissent latéralement entre eux des espaces E. Ces espaces E se situent entre les faces latérales des bâtonnets voisins au sein de l'agencement des bâtonnets. Par exemple, plus précisément, un espace E donné est délimité entre les faces latérales de quatre bâtonnets 16 voisins. On remarque que ces espaces E communiquent entre eux entre les bâtonnets.

Toujours en référence à la Figure 2, la source de lumière 12 comprend en outre un revêtement 20 adapté pour encapsuler les bâtonnets 16 et pour convertir au moins une partie de la lumière émise ou du rayonnement électromagnétique émis par les bâtonnets 16 en une lumière convertie. La lumière émise ou le rayonnement électromagnétique émis par les bâtonnets 16 porte la référence $I_e$ sur la Figure 2, et la lumière convertie porte la référence $I_c$.

Le revêtement 20 est au contact des bâtonnets 16. Le revêtement 20 est avantageusement également au contact du substrat 14. Le revêtement s'étend au-delà de l'extrémité libre des bâtonnets. En pratique, avantageusement, le revêtement se présente sous la forme d'une couche au contact du substrat et dont l'épaisseur est supérieure à l'encombrement vertical des bâtonnets (relativement à l'orientation de la Figure 2).

Le revêtement présente une épaisseur par exemple comprise entre 10 et 100 $\mu$m.

Le revêtement 20 comprend un matériau d'enrobage 22 et un matériau de conversion 24.

Le matériau d'enrobage 22 forme une matrice du revêtement à l'intérieur duquel le matériau de conversion est agencé. Le matériau d'enrobage définit alors la forme générale du revêtement, et plus spécifiquement sa configuration générale de couche.

Le matériau d'enrobage 22 est configuré pour protéger les bâtonnets 16. Par exemple, il est configuré pour les protéger mécaniquement et/ou chimiquement. En outre, il est transparent pour la lumière émise ou le rayonnement électromagnétique émis par les bâtonnets.

A cet effet, les bâtonnets 16 sont noyés dans le matériau d'enrobage 22 au moins en partie. Avantageusement, les bâtonnets 16 sont intégralement noyés dans le matériau d'enrobage 22.

Le matériau d'enrobage comprend avantageusement un polysiloxane.

Le matériau de conversion 24 est agencé dans le matériau d'enrobage 22. Il est configuré pour convertir au moins une partie de la lumière émise ou du rayonnement émis $I_e$ par les bâtonnets en la lumière convertie $I_c$. Dans le contexte de l'invention, le matériau de conversion 24 comprend au moins un composé luminophore 26.

Ici, par luminophore, on entend un matériau luminescent conçu pour absorber au moins une partie d'une lumière d'excitation émise ou un rayonnement électromagnétique d'excitation émis par une source lumineuse et pour convertir au moins une partie de cette lumière d'excitation absorbée ou de ce rayonnement électromagnétique d'excitation absorbé en une lumière d'émission ayant une longueur d'onde différente de celle de la lumière d'excitation ou de celle du rayonnement électromagnétique d'excitation. Ici, ces lumières correspondant donc à la lumière émise ou rayonnement électromagnétique émis $I_e$ et à la lumière convertie $I_c$.

Dans le contexte de l'invention, le matériau de conversion 24 est configuré pour absorber toute la lumière émise ou tout le rayonnement électromagnétique émis par les bâtonnets en direction de la glace de fermeture, ou bien seulement une partie.

En pratique, cette modalité est conditionnée par la couleur de la lumière souhaitée pour le module 10, qui résulte de la combinaison de la lumière $I_e$ qui traverse le matériau de conversion 24 sans y être absorbée (s'il y en), et la lumière convertie $I_c$ résultant de l'absorption d'une partie de la lumière émise $I_e$. La quantité de composé luminophore 26 (ou de matériau de conversion de façon générale) peut alors être ajustée pour contrôler la proportion de la lumière $I_e$ qui est convertie en lumière $I_c$.

Le composé luminophore 26 se présente sous la forme de grains luminophores, ou particules, 30 agencés dans le matériau d'enrobage 22. Les grains 30 se situent plus spécifiquement dans une zone 31 du revêtement qui s'étend au-delà de l'extrémité libre des bâtonnets.

Avantageusement, les grains 30 de la sous-couche de conversion 24 sont accumulés au sein d'une épaisseur e de la zone 31 qui est proximale relativement aux bâtonnets 16. Autrement dit, les grains 30 sont principalement situés dans la portion de la zone du revêtement surplombant les bâtonnets qui se situe au plus proche de l'extrémité des bâtonnets 16. Avantageusement, ils sont accumulés directement au contact des extrémités libres des bâtonnets.

Les grains définissent ainsi une couche de conversion au sein du revêtement qui surplombe les bâtonnets. Avantageusement, cette couche de conversion présente une épaisseur comprise entre 30 micromètres et 50 micromètres, et valant par exemple sensiblement 40 micromètres.

Le composé luminophore 26 est avantageusement un matériau fluorescent, c'est-à-dire un composé configuré pour émettre de la lumière par fluorescence. Alternativement ou parallèlement, le composé luminophore est phosphorescent.

On remarque que dans certaines réalisations, le matériau de conversion 24 comprend plus d'un composé luminophore.

Par exemple, le matériau de conversion 24 comprend au moins un composé luminophore 26 du groupe suivant : $Y_3Al_5O_{12}$:$Ce^{3+}$ (YAG), $(Sr, Ba)_2SiO_4$:$Eu^{2+}$, $Ca_x(Si,Al)_{12}(O,N)_{16}$:$Eu^{2+}$, $CaAlSiN_3$:$Eu^{2+}$, $Ca_2Si_5N_8$:$Eu^{2+}$, $La_2O_2S$:$Eu^{3+}$, $(Sr, Ca, Ba, Mg)_{10}(PO_4)_6Cl_2$:$EU^{2+}$, $BaMgAl_{10}O_{17}$:$Eu^{2+}$, $(Si, Al)_6(O, N)$:$Eu^{2+}$, $BaMgAl_{10}O_{17}$:$EU^{2+}Mn^{2+}$, $SrS$:$Eu^{2+}$, $Sr_2Si_5N_8$:$Eu^{2+}$, $SrGa_2S_4$:$Eu^{2+}$, $(Y,Gd)_3(Al, Ga)_5O_{12}$:$Ce^{3+}$ / $(Ba,Sr,Ca)Si_2O_4$:$Eu^{2+}$.

Les composés luminophores $Y_3Al_5O_{12}$:$Ce^{3+}$ (YAG), $(Sr,Ba)_2SiO_4$:$Eu^{2+}$, et $Ca_x(Si,Al)_{12}(O,N)_{16}$:$Eu^{2+}$ sont configurés pour absorber au moins en partie une lumière d'excitation de couleur bleue et pour émettre en réponse de la lumière de couleur jaune.

Les composés luminophores $SrS$:$Eu^{2+}$, et $Sr_2Si_5N_8$:$Eu^{2+}$ sont configurés pour absorber au moins en partie une lumière d'excitation de couleur bleue et pour émettre en réponse de la lumière de couleur rouge.

Le composé luminophore $(Y,Gd)_3(Al, Ga)_5O_{12}$:$Ce^{3+}$ / $(Ba,Sr,Ca)Si_2O_4$:$Eu^{2+}$ est configuré pour absorber au moins en partie une lumière d'excitation de couleur bleue et pour émettre en réponse de la lumière blanche.

Les composés luminophores $(Si, Al)_6(O, N)$:$Eu^{2+}$, $BaMgAl_{10}O_{17}$:$EU^{2+}Mn^{2+}$, et $SrGa_2S_4$:$Eu^{2+}$ sont configurés pour absorber au moins en partie un rayonnement électromagnétique d'excitation ultra-violet et pour émettre en réponse de la lumière de couleur verte.

Les composés luminophores $(Sr, Ca, Ba, Mg)_{10}(PO_4)_6Cl_2$:$Eu^{2+}$, et $BaMgAl_{10}O_{17}$:$EU^{2+}$ sont configurés pour absorber au moins en partie un rayonnement électromagnétique d'excitation ultra-violet et pour émettre en réponse de la lumière de couleur bleue.

Les composés luminophores $CaAlSiN_3$:$Eu^{2+}$, $Ca_2Si_5N_8$:$EU^{2+}$, et $La_2O_2S$:$Eu^{3+}$ sont configurés pour absorber au moins en partie un rayonnement électromagnétique d'excitation ultra-violet et pour émettre en réponse de la lumière de couleur rouge.

Dans une variante de réalisation, les composés luminophores n'absorbent pas la totalité de la lumière d'excitation. Il est alors possible d'obtenir la synthèse additive entre la lumière d'excitation et la lumière émise par le luminophore. Ainsi les composés luminophores $Y_3Al_5O_{12}$:$Ce^{3+}$ (YAG), $(Sr,Ba)_2SiO_4$:$Eu^{2+}$, et $Ca_x(Si, Al)_{12}(O,N)_{16}$:$Eu^{2+}$ permettent d'obtenir une lumière blanche grâce à la synthèse additive de la lumière d'excitation de couleur bleu et la lumière émise en réponse qui est alors de couleur jaune.

Les grains luminophores 30 présentent une forme quelconque.

Dans le contexte de l'invention, les grains 30 présentent des dimensions adaptées pour prévenir la présence des grains dans les espaces E délimités latéralement entres les bâtonnets 18. Plus spécifiquement, les dimensions des grains 30 sont configurées pour prévenir la présence des grains 30 entre les bâtonnets d'une zone d'émission donnée.

Ici, par « présence des grains entre les bâtonnets », on entend que les grains ne sont pas intégralement situés dans les espaces E. Avantageusement, au plus une portion d'extrémité d'un ou plusieurs grains se trouve entre les bâtonnets, et elle se situe alors au niveau des extrémités libres des bâtonnets opposées au substrat 14, comme illustré pour le grain le plus à gauche en Figure 2.

A cet effet, les grains 30 ont des dimensions supérieures aux dimensions maximales autorisant la présence des grains 30 dans les espaces E entre les bâtonnets 16, et ce quelle que soit l'orientation des grains envisagée.

La valeur de ces dimensions maximales est variable en fonction de l'agencement des bâtonnets 16 sur le substrat 14 et la configuration des bâtonnets et de la forme de chaque grain.

Ici, on appelle « diamètre d'une particule » la longueur d'un segment joignant deux points de la surface de la particule et passant par le centre de gravité de la particule. Une particule 30 donnée de forme quelconque présente une pluralité de diamètres, dont un diamètre minimal et un diamètre maximal.

Aussi, dans le contexte de l'invention, avantageusement, le diamètre minimal des grains 30 est supérieur à la plus grande des distances de l'ensemble des distances entre deux bâtonnets définissant conjointement un espace E donné (éventuellement conjointement à un ou plusieurs autres bâtonnets) et ce pour l'ensemble des bâtonnets de la zone d'émission.

Autrement dit, pour un espace E donné, on considère la plus grande des distances entre deux des bâtonnets définissant l'espace E. On considère ensuite la plus grande de ces distances parmi l'ensemble des espaces E. Cette distance constitue alors avantageusement la borne inférieure (avantageusement strictement) du diamètre minimal des grains 30. On remarque que pour un agencement matriciel régulier, la distance maximale pour un espace E est sensiblement la même que pour les autres espaces E.

Alternativement, c'est le diamètre maximal des grains 30 qui est supérieur à cette distance.

Par exemple, pour un agencement matriciel des bâtonnets, cette distance est définie par deux bâtonnets appartenant à des lignes et des colonnes distinctes. Le diamètre minimal des grains 30 est supérieur à $\sqrt{p1^2 + p2^2}$, où p1 et p2 sont les pas d'espacement des bâtonnets selon l'une et l'autre des directions de l'agencement matriciel.

Une caractérisation plus précise du diamètre minimal des grains est envisagée sur la base de l'échelle dite « Krumbein phi ».

Par exemple, pour un espacement des bâtonnets voisins compris entre 3 $\mu$m et 10 $\mu$m, le diamètre minimal des grains correspond à une échelle $\phi$ de valeur. Pour un espacement compris entre 3 $\mu$m et 10 $\mu$m, le diamètre minimal correspond à une échelle $\phi$ de valeur.

On remarque que dans une configuration dans laquelle le module 10 présente une pluralité de zones d'émission de lumière toutes encapsulées par le revêtement 20 et séparées par des espaces tampons ne présentant pas de bâtonnets, il n'est pas exclu des grains 30 soient présents dans les espaces tampons entre les zones d'émission, qui ne correspondent pas à des espaces E délimités par des bâtonnets voisins. En outre, pour une zone d'émission présentant au moins une région dépourvue de bâtonnets, il n'est pas exclu que des grains 30 soient présents dans cette ou ces régions, qui ne sont alors pas non plus définies entre des bâtonnets voisins.

Le procédé de fonctionnement du module 10 et du dispositif d'émission lumineuse 2 va maintenant être décrit en référence aux Figures.

Lorsque les bâtonnets 16 sont alimentés en énergie électrique via le substrat, ils émettent de la lumière ou un rayonnement électromagnétique dit d'excitation $I_e$. Au moins une partie de cette lumière ou de ce rayonnement électromagnétique d'excitation présente un trajet intersectant au moins un grain 30. Au moins une partie de cette lumière ou rayonnement électromagnétique d'excitation est alors absorbé par un ou des grains du (ou d'un) composé luminophore. En réponse, le composé luminophore 26 émet la lumière convertie $I_c$ de manière sensiblement isotrope, avantageusement par fluorescence. Au moins une partie de la lumière $I_e$ non absorbée est émise en direction de la glace de fermeture 6, et au moins une partie de la lumière convertie est également émise en direction de la glace de fermeture. Ces lumières traversent la glace, éventuellement après mise en forme par l'élément optique de mise en forme 11, et/ou passage par une optique de mise en forme du module 10 agencée en regard des bâtonnets et du revêtement.

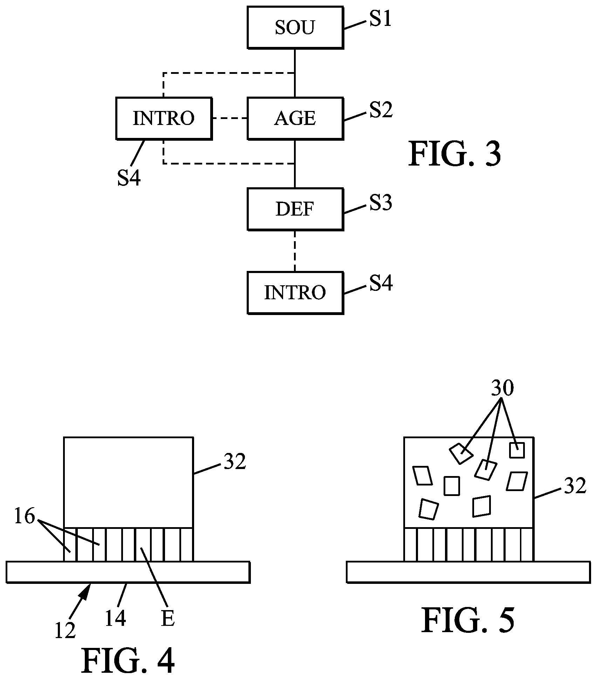

Un procédé de fabrication du module 10 va maintenant être décrit en référence aux Figures, notamment à la Figure 3.

De manière générale, le procédé de fabrication comprend :

- une étape S1 d'obtention de la source de lumière 12,
- une étape S2 de formation au cours de laquelle on forme, sur les bâtonnets électroluminescents 16 de la source de lumière 12, une couche de préparation 32 destinée à former tout ou partie du revêtement,
- une étape S3 de déformation au cours de laquelle la couche de préparation 32 est déformée de façon à emplir les espaces E délimités latéralement entre les bâtonnets, et
- une étape postérieure à l'étape de déformation au cours de laquelle on forme le revêtement à partir d'au moins la couche de préparation.

Le procédé comprend en outre une étape d'introduction S4 au cours de laquelle on introduit les grains 30 de composé luminophore dans le procédé de fabrication.

Le détail du déroulement du procédé de fabrication est variable en fonction du moment où intervient cette étape d'introduction.

En référence à la Figure 5, qui illustre le résultat de l'étape S2 dans le cadre d'une première réalisation, les grains 30 sont introduits dans un matériau à partir duquel la couche de préparation 32 est réalisée préalablement à la formation de la couche de préparation 32 sur les bâtonnets 16.

Quelle que soit la réalisation envisagée, la couche 32 se présente par exemple sous la forme d'une couche située sur les bâtonnets. Au moins immédiatement après sa formation, sa matière n'emplit pas les espaces E situés entre les bâtonnets. Avantageusement, la couche de préparation est formée au moyen d'un moule empêchant le transfert de la matière de la couche 32 vers des régions indésirées.

Par exemple, la couche 32 est formée sur l'intégralité de la zone d'émission considérée d'un seul tenant, ou bien par portions successives.

Pour l'introduction des grains 30 dans le procédé préalablement à la formation de la couche 32, on procède par exemple de manière connue, en mélangeant le matériau en question et les grains de façon à les noyer dans ce matériau.

Le matériau en question est avantageusement un précurseur du matériau destiné à former le matériau d'enrobage. Par exemple, il s'agit d'un précurseur de polysiloxane.

Aussi, dans cette réalisation, on introduit les grains 30 dans ce matériau, suite à quoi on dépose le mélange obtenu sur les bâtonnets 16 de façon à former la couche de préparation 32.

Dans une deuxième réalisation, en référence aux Figures 4 et 5, on introduit les grains 30 postérieurement à la formation de la couche de préparation 32 sur les bâtonnets 16.

Par exemple, les grains sont alors insérés dans le matériau de la couche de préparation par l'interface supérieure de la couche 32 (au sens de l'orientation de la Figure 5).

Une fois la couche de préparation 32 formée sur les bâtonnets 16, lors de l'étape de déformation, la couche 32 est déformée de sorte que son matériau emplisse les espaces E.

Lors de l'étape de déformation, le matériau de la couche de préparation 32 (autre que les grains qu'elle comprend) descend ou s'effondre pour emplir les espaces E entre les bâtonnets. Du fait de ce transfert de matière, et éventuellement sous l'action conjuguée de la gravité, les grains 30 tendent à se déplacer en direction de l'extrémité des bâtonnets opposée au substrat 14, où ils s'accumulent dans l'épaisseur e décrite ci-dessus du fait de leur dimensions. Ceci aboutit à la formation de la couche de conversion, qui se situe alors avantageusement au plus proche des extrémités des bâtonnets 16.

Avantageusement, un moule entourant tout ou partie de la zone d'émission considérée est utilisé pour prévenir le transfert de la matière de la couche 32 vers des régions indésirables lors de la formation de cette dernière, comme les bords du substrat.

Plusieurs modes de réalisation de l'étape de déformation sont envisagés.

Dans une premier mode de réalisation, le matériau de la couche de préparation 32 (autre que les grains 30 éventuellement déjà introduits) est un matériau thermoplastique.

Aussi, lors de l'étape de déformation, on provoque la déformation de ce matériau en lui fournissant de la chaleur. Sous l'effet de cette chaleur, le matériau devient déformable et s'effondre de façon à emplir les espaces E entre les bâtonnets 16.

Dans un deuxième mode de réalisation, le matériau de la couche de préparation 32 est thermodurcissable. Autrement dit, le matériau est initialement déformable et durcit sous l'effet de la chaleur.

Lors de l'étape de déformation, une fois formée sur les bâtonnets 16, la couche de préparation 32 se déforme naturellement du fait du caractère plastique du matériau de la couche 32. La matière de la couche 32 se déplace alors en direction du substrat de façon à emplir les espaces E.

Comme précédemment, du fait du transfert de matière de la couche 32 vers le substrat, les grains 30 tendent à se déplacer en direction des extrémités des bâtonnets 16 et s'accumulent sur ces extrémités ou à leur voisinage du fait de leurs dimensions qui empêchent leur descente entre les bâtonnets.

Une fois la configuration de la couche de préparation souhaitée obtenue, on fige cette forme. Par exemple, pour ce faire, on refroidit le revêtement s'il est thermoplastique, ou on le chauffe s'il est thermodurcissable.

En référence à la Figure 4, dans une troisième réalisation relative à l'étape S4, on introduit les grains 30 une fois l'étape de déformation achevée.

Autrement dit, la couche de préparation 32 soumise à l'étape de déformation est dépourvue de grains 30, ceux-ci étant introduits dans le matériau résultant de la déformation de la couche 32 qui s'étend au-delà de l'extrémité des bâtonnets 16 une fois l'étape de déformation menée.

Pour ce faire, par exemple et comme précédemment, on insère les grains 30 dans ce matériau par l'interface supérieure de cette couche de façon à former la sous-couche 24.

Pour la formation effective du revêtement à partir de la couche de préparation déformée dans les configurations où le matériau d'enrobage est le résultat de la transformation d'un précurseur (qui correspond au matériau de la couche de préparation autre que les grains), on transforme ce précurseur en le matériau d'enrobage. On emploie par exemple un procédé connu pour ce faire, tel qu'une polymérisation.

Dans une variante relative à l'étape d'introduction également illustrée par la Figure 3, l'étape d'introduction est réalisée après la transformation du précurseur en le matériau d'enrobage. Autrement dit, la couche de préparation est dépourvue de grains, elle est ensuite déformée, puis transformée pour former le matériau d'enrobage. Les grains sont alors introduits directement dans le matériau d'enrobage. Cette introduction est par exemple réalisée alors par la face supérieure de la couche formée par le matériau d'enrobage.

On remarque que dans cette variante, l'obtention d'une couche de conversion homogène au voisinage de l'extrémité libre des bâtonnets est moins aisée.

Le module selon l'invention présente plusieurs avantages.

Tout d'abord, la configuration de la couche 20 d'encapsulation, et en particulier l'absence de grains entre les bâtonnets, a pour effet d'améliorer l'homogénéité spatiale de la couleur obtenue à l'issue de la conversion de la lumière émise par le composé luminophore.

Cet effet est en outre renforcé par la disposition accumulée des grains à l'extrémité des bâtonnets. En effet, cette configuration des grains se traduit par la présence d'une couche de conversion compacte et de bonne homogénéité à l'extrémité des bâtonnets, ce qui a pour effet d'harmoniser les phénomènes auxquels est soumise la lumière émise par les différents bâtonnets.

En outre, ceci est obtenu à partir d'un procédé de fabrication simple et adaptable, qui permet d'émuler un procédé de dépôt d'une couche mince de conversion, qui n'est pas aisé pour des composés luminophores se présentant généralement sous la forme de grains.

## Revendications

1. Source d'émission lumineuse comprenant :

    - une pluralité de bâtonnets électroluminescents (16) de dimensions submillimétriques configurés pour émettre de la lumière, et
    - un revêtement (20) adapté pour encapsuler les bâtonnets électroluminescents et pour convertir au moins une partie de la lumière émise par les bâtonnets en une lumière convertie, le revêtement comprenant :

        ◦ un matériau d'enrobage (22) dans lequel au moins une partie des bâtonnets électroluminescents (16) est enrobée, et
        ◦ un matériau de conversion (24) adapté pour générer ladite lumière convertie à partir de la lumière émise par les bâtonnets électroluminescents, le matériau de conversion comprenant une pluralité de grains luminophores (30), les grains luminophores se situant dans une zone du revêtement s'étendant au-delà d'extrémités libres des bâtonnets électroluminescents, les grains luminophores présentant des dimensions configurées pour prévenir la présence desdits grains luminophores entre des espaces délimités latéralement entre les bâtonnets électroluminescents, les grains présentant un diamètre minimal supérieur à la plus grande des distances d'un ensemble de distances définies entre deux bâtonnets voisins dans une zone d'émission.

2. Source d'émission lumineuse selon la revendication 1, dans laquelle les bâtonnets électroluminescents sont noyés dans le matériau d'enrobage.

3. Source d'émission lumineuse selon la revendication 1 ou 2, dans laquelle au moins une partie des grains luminophores (30) est accumulée au sein d'une épaisseur du revêtement qui surplombe l'extrémité libre des bâtonnets électroluminescents (16).

4. Source d'émission lumineuse selon la revendication 3, dans laquelle ladite épaisseur est au contact de l'extrémité libre des bâtonnets électroluminescents.

5. Source d'émission lumineuse selon l'une quelconque des revendications précédentes, dans laquelle ladite zone du revêtement présente une épaisseur comprise entre 10 et 100 micromètres.

6. Source d'émission lumineuse selon l'une quelconque des revendications précédentes, dans laquelle le matériau d'enrobage comprend un polymère thermoplastique ou thermodurcissable.

7. Source d'émission lumineuse selon la revendication 6, dans laquelle ledit matériau d'enrobage comprend un polysiloxane.

8. Source d'émission lumineuse selon l'une quelconque des revendications précédentes, dans laquelle les grains luminophores comprennent au moins un composé luminophore pris seul ou en combinaison parmi : $Y_3Al_5O_{12}:Ce^{3+}$ (YAG), $(Sr,Ba)_2SiO_4:Eu^{2+}$, $Ca_x(Si,Al)_{12}(O,N)_{16}:Eu^{2+}$, $CaAlSiN_3:Eu^{2+}$, $Ca_2Si_5N_8:Eu^{2+}$, $La_2O_2S:Eu^{3+}$, $(Sr, Ca, Ba, Mg)_{10}(PO_4)_6Cl_2:Eu^{2+}$, $BaMgAl_{10}O_{17}:Eu^{2+}$, $(Si, Al)_6(O, N):Eu^{2+}$, $BaMgAl_{10}O_{17}:Eu^{2+}Mn^{2+}$, $SrS:Eu^{2+}$, $Sr_2Si_5N_8:Eu^{2+}$, $SrGa_2S_4:Eu^{2+}$, $(Y,Gd)_3(Al, Ga)_5O_{12}:Ce^{3+}$ / $(Ba,Sr,Ca)Si_2O_4:Eu^{2+}$.

9. Module d'émission lumineuse adapté pour émettre de la lumière, le module d'émission lumineuse comprenant une source d'émission lumineuse selon l'une quelconque des revendications précédentes.

10. Module d'émission lumineuse selon la revendication 9, comprenant en outre un substrat à partir duquel les bâtonnets électroluminescents s'étendent.

11. Module d'émission lumineuse selon la revendication 9 ou 10, comprenant en outre un module de contrôle adapté pour commander l'alimentation en énergie électrique des bâtonnets électroluminescents.

12. Module d'émission lumineuse selon l'une quelconque des revendications 9 à 11, comprenant en outre une optique de mise en forme agencée pour recevoir la lumière émise par le module d'émission lumineuse pour former un faisceau lumineux.

13. Dispositif d'émission lumineuse, notamment pour véhicule automobile, comprenant un module d'émission lumineuse (10) selon l'une quelconque des revendications 9 à 12.

14. Dispositif d'émission lumineuse selon la revendication 13, dans lequel le dispositif d'émission lumineuse comprend en outre un élément optique de mise en forme adapté pour recevoir la lumière par le module d'émission lumineuse pour former un faisceau de sortie du dispositif d'émission lumineuse.

15. Dispositif d'émission lumineuse selon la revendication 13 ou 14, le dispositif étant configuré pour mettre en œuvre une fonction photométrique, notamment réglementaire pour véhicule automobile.

16. Procédé de fabrication d'une source d'émission lumineuse selon l'une quelconque des revendications précédentes, le procédé comprenant :

- une étape d'obtention des bâtonnets électroluminescents (16),
- une étape de formation au cours de laquelle on forme, sur les bâtonnets électroluminescents (16) de la source de lumière, une couche de préparation (32) destinée à former tout ou partie du revêtement adapté pour encapsuler les bâtonnets électroluminescents et pour convertir au moins une partie de la lumière émise par les bâtonnets en une lumière convertie,
- une étape de déformation au cours de laquelle la couche de préparation est déformée de façon à emplir des espaces (E) délimités latéralement entre les bâtonnets, et
- une étape postérieure à l'étape de déformation au cours de laquelle on forme le revêtement à partir d'au moins la couche de préparation.

**Patentansprüche**

1. Lichtemissionsquelle, die Folgendes beinhaltet:

- eine Vielzahl von elektrolumineszierenden Stäbchen (16) mit Größen im Submillimeterbereich, die dazu konfiguriert sind, Licht zu emittieren, und
- eine Beschichtung (20), die dazu angepasst ist, die elektrolumineszierenden Stäbchen zu verkapseln und mindestens einen Teil des durch die Stäbchen emittierten Lichts in ein konvertiertes Licht zu konvertieren, wobei die Beschichtung Folgendes beinhaltet:

○ ein Umhüllungsmaterial (22), das mindestens einen Teil der elektrolumineszierenden Stäbchen (16) umhüllt, und
○ ein Konvertierungsmaterial (24), das dazu angepasst ist, das konvertierte Licht aus dem durch die elektrolumineszierenden Stäbchen emittierten Licht zu erzeugen, wobei das Konvertierungsmaterial eine Vielzahl von Leuchtstoffkörnern (30) beinhaltet, wobei sich die Leuchtstoffkörner in einem Bereich der Beschichtung befinden, der sich über freie Enden der elektrolumineszierenden Stäbchen hinaus erstreckt, wobei die Leuchtstoffkörner Größen aufweisen, die dazu konfiguriert sind, das Vorhandensein der Leuchtstoffkörner zwischen Räumen, die seitlich zwischen den elektrolumineszierenden Stäbchen begrenzt werden, zu verhindern, wobei die Leuchtstoffkörner einen Mindestdurchmesser aufweisen, der größer als der größte der Abstände eines Satzes von Abständen ist, die in einem Emissionsbereich zwischen zwei benachbarten Stäbchen definiert sind.

2. Lichtemissionsquelle nach Anspruch 1, wobei die elektrolumineszierenden Stäbchen in das Umhüllungsmaterial eingebettet sind.

3. Lichtemissionsquelle nach Anspruch 1 oder 2, wobei mindestens ein Teil der Leuchtstoffkörner (30) innerhalb einer Dicke der Beschichtung angesammelt ist, die über dem freien Ende der elektrolumineszierenden Stäbchen (16) liegt.

4. Lichtemissionsquelle nach Anspruch 3, wobei die Dicke mit dem freien Ende der elektrolumineszierenden Stäbchen in Kontakt ist.

5. Lichtemissionsquelle nach einem der vorhergehenden Ansprüche, wobei der Bereich der Beschichtung eine Dicke zwischen 10 und 100 Mikrometern aufweist.

6. Lichtemissionsquelle nach einem der vorhergehenden Ansprüche, wobei das Umhüllungsmaterial ein thermoplastisches oder thermohärtbares Polymer beinhaltet.

7. Lichtemissionsquelle nach Anspruch 6, wobei das Umhüllungsmaterial ein Polysiloxan beinhaltet.

8. Lichtemissionsquelle nach einem der vorhergehenden Ansprüche, wobei die Leuchtstoffkörner mindestens eine Leuchtstoffzusammensetzung beinhalten, die alleine oder in Kombination aus Folgendem ausgewählt ist: $Y_3Al_5O_{12}:Ce^{3+}$ (YAG), $(Sr,Ba)_2SiO_4:Eu^{2+}$, $Ca_x(Si,Al)_{12}(O,N)_{16}:Eu^{2+}$, $CaAlSiN_3:Eu^{2+}$, $Ca_2Si_5N_8:EU^{2+}$, $La_2O_2S:Eu^{3+}$, $(Sr, Ca, Ba, Mg)_{10}(PO_4)_6Cl_2:EU^{2+}$, $BaMgAl_{10}O_{17}:Eu^{2+}$, $(Si, Al)_6(O, N):EU^{2+}$, $BaMgAl_{10}O_{17}:Eu^{2+}Mn^{2+}$, $SrS:Eu^{2+}$, $Sr_2Si_5N_8:Eu^{2+}$, $SrGa_2S_4:Eu^{2+}$, $(Y, Gd)_3(Al,Ga)_5O_{12}: Ce^{3+}$ / $(Ba, Sr, Ca)Si_2O_4:Eu^{2+}$.

**9.** Lichtemissionsmodul, das dazu angepasst ist, Licht zu emittieren, wobei das Lichtemissionsmodul eine Lichtemissionsquelle nach einem der vorhergehenden Ansprüche beinhaltet.

**10.** Lichtemissionsmodul nach Anspruch 9, das ferner ein Substrat beinhaltet, von dem aus sich die elektrolumineszierenden Stäbchen erstrecken.

**11.** Lichtemissionsmodul nach Anspruch 9 oder 10, das ferner ein Steuermodul beinhaltet, das dazu angepasst ist, die elektrische Energieversorgung der elektrolumineszierenden Stäbchen zu steuern.

**12.** Lichtemissionsmodul nach einem der Ansprüche 9 bis 11, das ferner eine Formungsoptik beinhaltet, die angeordnet ist, um das durch das Lichtemissionsmodul emittierte Licht zu empfangen, um einen Lichtstrahl zu formen.

**13.** Lichtemissionsvorrichtung, insbesondere für ein Kraftfahrzeug, die ein Lichtemissionsmodul (10) nach einem der Ansprüche 9 bis 12 beinhaltet.

**14.** Lichtemissionsvorrichtung nach Anspruch 13, wobei die Lichtemissionsvorrichtung ferner ein optisches Formungselement beinhaltet, das dazu angepasst ist, das Licht durch das Lichtemissionsmodul zu empfangen, um einen Ausgangsstrahl der Lichtemissionsvorrichtung zu formen.

**15.** Lichtemissionsvorrichtung nach Anspruch 13 oder 14, wobei die Vorrichtung dazu konfiguriert ist, eine fotometrische Funktion, die insbesondere für ein Kraftfahrzeug vorgeschrieben ist, umzusetzen.

**16.** Verfahren zur Fertigung einer Lichtemissionsquelle nach einem der vorhergehenden Ansprüche, wobei das Verfahren Folgendes beinhaltet:

- einen Schritt des Erhaltens der elektrolumineszierenden Stäbchen (16),
- einen Formungsschritt, während dessen auf den elektrolumineszierenden Stäbchen (16) der Lichtquelle eine Vorbereitungsschicht (32) geformt wird, die dazu bestimmt ist, die gesamte oder einen Teil der Beschichtung zu formen, welche dazu angepasst ist, die elektrolumineszierenden Stäbchen zu verkapseln und mindestens einen Teil des durch die Stäbchen emittierten Lichts in ein konvertiertes Licht zu konvertieren,
- einen Verformungsschritt, während dessen die Vorbereitungsschicht so verformt wird, dass Räume (E), die seitlich zwischen den Stäbchen begrenzt werden, ausgefüllt werden, und
- einen Schritt nach dem Verformungsschritt, während dessen die Beschichtung aus mindestens der Vorbereitungsschicht geformt wird.

**Claims**

**1.** Light-emitting source comprising:

a plurality of electroluminescent rods (16) of submillimetre dimensions configured to emit light, and
a coating (20) adapted for encapsulating the electroluminescent rods and for converting at least a portion of the light emitted by the rods into a converted light, the coating comprising:

a coating material (22) in which at least a portion of the electroluminescent rods is embedded, and
a conversion material (24) adapted for generating said converted light from the light emitted by the electroluminescent rods, the conversion material comprising a plurality of phosphor grains (30), the phosphor grains being located in an area of the coating extending beyond free ends of the electroluminescent rods, and the phosphor grains having dimensions configured to prevent the presence of said phosphor grains between spaces delimited laterally between the electroluminescent rods, the grains having a minimum diameter greater than the largest distance of a group of distances between two electroluminescent rods jointly defining one of said spaces.

**2.** Light-emitting source according to claim 1, wherein the electroluminescent rods are embedded in the coating material.

**3.** Light-emitting source according to claim 1 or 2, wherein at least a portion of the phosphor grains is accumulated in a thickness of the coating which overhangs the free end of the electroluminescent rods.

**4.** Light-emitting source according to claim 3, wherein said thickness is in contact with the free end of the electroluminescent rods.

**5.** Light-emitting source according to any of the preceding claims, wherein said area of the coating has a thickness of between 10 and 100 $\mu$m.

**6.** Light-emitting source according to any of the preceding claims, wherein the coating material comprises a thermoplastic or thermosetting polymer.

**7.** Light-emitting source according to claim 6, wherein the coating material comprises a polysiloxane.

8. Light-emitting source according to any of the preceding claims, wherein the phosphor grains comprise at least one phosphor compound taken alone or in combination from: Y 3A1 150 12:Ce 3+(YAG), (Sr,Ba) 2SiO 4:Eu 2+, Ca x(Si,Al) 12(0,N) 16:Eu 2+, CaAlSiN 3:Eu 2+, Ca 2Si 5N 8:Eu 2+, La 2O 2S:Eu 3+, (Sr, Ca, Ba, Mg) 10(PO 4) 6C12:Eu 2+, BaMgAl 100 17:Eu 2+, (Si, Al) 6 (O, N):Eu 2+, BaMgAl 100 17:Eu 2+Mn 2+, SrS:Eu 2+, Sr 2Si 5N 8:Eu 2+, SrGa 2S 4:Eu 2+, and (Y,Gd) 3(Al,Ga) 5O 12:Ce 3+/(Ba,Sr, Ca)Si 2O 4:Eu 2+.

9. Light-emitting module adapted for emitting light, the light-emitting module comprising a light-emitting source according to any of the preceding claims.

10. Light-emitting module according to claim 9, also comprising a substrate from which the electroluminescent rods extend.

11. Light-emitting module according to claim 9 or 10, also comprising a control module adapted for controlling the supply of electric power to the electroluminescent rods.

12. Light-emitting module according to any of claims 9 to 11, also comprising shaping optics arranged for receiving the light emitted by the light-emitting module in order to form a light beam.

13. Light-emitting device, comprising a light-emitting module according to any of claims 9 to 12.

14. Light-emitting device according to claim 13, wherein the light-emitting device also comprises shaping optics adapted for receiving the light emitted by the light-emitting module for forming an output beam of the light-emitting device.

15. Light-emitting device according to claim 18, the device being configured to implement a photometric function.

16. Method for producing a light-emitting source according to claim 1, the method comprising:

    a step of obtaining the electroluminescent rods, a formation step during which is formed, on the electroluminescent rods of the light source, a preparation layer intended to form all or part of the coating adapted for encapsulating the electroluminescent rods and for converting at least a portion of the light emitted by the rods into a converted light,
    a deformation step during which the preparation layer is deformed so as to fill spaces delimited laterally between the rods, and
    a step following the deformation step during which the coating is formed from at least the preparation layer.

FIG. 1

FIG. 2

FIG. 3

FIG. 4

FIG. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015207038 A

- US 2012132888 A